(19)

Europäisches
Patentamt
European
Patent Office
Office européen
des brevets

(11)  **EP 1 443 645 B1**

(12)  **EUROPEAN PATENT SPECIFICATION**

(45) Date of publication and mention
of the grant of the patent:
**06.01.2010 Bulletin 2010/01**

(51) Int Cl.:
***H03H 17/06*** *(2006.01)*

(21) Application number: **03104135.3**

(22) Date of filing: **10.11.2003**

(54) **Linearly scalable finite impulse response (FIR) filter**

Linear skalierbares Filter mit endlicher Impulsantwort

Filtre à réponse impulsionnelle finie échelonnable de façon linéaire

(84) Designated Contracting States:
**DE FR GB IT**

(30) Priority: **18.11.2002 IN DE11662002**

(43) Date of publication of application:
**04.08.2004 Bulletin 2004/32**

(73) Proprietor: **STMicroelectronics Pvt. Ltd.**
**201 302 Uttar Pradesh (IN)**

(72) Inventors:
• **SAHA, Kaushik**
**110 054, Delhi (IN)**
• **MAITI, Srijib Narayan**
**721101, Midnapore, W.B. (IN)**

(74) Representative: **Maccalli, Marco et al**
**Maccalli & Pezzoli S.r.l.,**
**Via Settembrini, 40**
**20124 Milano (IT)**

(56) References cited:
**EP-A- 0 285 316       EP-A- 0 818 740**
**US-B1- 6 260 053       US-B1- 6 308 191**

• **DICK C H ED - SINGH A: "The scalability of linear filters on hypercube concurrent computers" SIGNALS, SYSTEMS AND COMPUTERS, 1994. 1994 CONFERENCE RECORD OF THE TWENTY-EIGHTH ASILOMAR CONFERENCE ON PACIFIC GROVE, CA, USA 31 OCT.-2 NOV. 1994, LOS ALAMITOS, CA, USA,IEEE COMPUT. SOC, US, 31 October 1994 (1994-10-31), pages 1069-1073, XP010148742 ISBN: 0-8186-6405-3**

• **WILKINSON, BARRY: "Digital System Design" 1987, PRENTICE-HALL INTERNATIONAL (UK) LTD. , CAMBRIDGE 870680 , XP002287989 * pages 460-463 * * pages 472-473 ***
• **"Datasheet - TMS320C30 Digital Signal Processor" 1997, TEXAS INSTRUMENTS , XP002287990 * pages 1,12 ***
• **SLUMP C H ET AL: "Design And Implementation Of A Linear-phase Equalizer In Digital Audio Signal Processing" IEEE WORKSHOP ON VLSI SIGNAL PROCESSING, V, 28 October 1992 (1992-10-28), pages 297-306, XP010259013**
• **MOU AND P DUHAMEL Z J: "Fast FIR Filtering: Algorithms and Implementations" SIGNAL PROCESSING, AMSTERDAM, NL, vol. 13, December 1987 (1987-12), pages 377-384, XP002105471 ISSN: 0165-1684**
• **EYRE J.; BIER J.: 'The Evolution of DSP Processors - From Early Architectures to the Latest Developments' IEEE SIGNAL PROCESSING MAGAZINE March 2000, pages 43 - 51, XP011089859**
• **SERNEC R. ET AL: 'The evolution of DSP architectures: towards parallelism exploitation' 10TH MEDITERRANEAN ELECTROTECHNICAL CONFERENCE, MELECON 2000 29 May 2000 - 31 May 2000, pages 782 - 785, XP010517907**
• **DEKA R.: 'A comprehensive study of digital signal processing devices' MICROPROCESSORS AND MICROSYSTEMS vol. 19, no. 4, 04 May 1995, LONDON, GB, pages 209 - 221, XP004032608**
• **ZHI-JIAN MOU: "A STUDY OF VLSI SYMMETRIC FIR FILTER STRUCTURES" JOURNAL OF VLSI SIGNAL PROCESSING SYSTEMS FOR SIGNAL, IMAGE, AND VIDEO TECHNOLOY, vol. 4, no. 4, 1 November 1992 (1992-11-01), pages 371-377, XP000330843 NEW YORK, NY, US**

## Description

The invention relates to Finite Impulse Response (FIR) Digital Filters. More specifically, the invention relates to an efficient implementation for Finite Impulse Response filters in a multi-processor architecture.

Finite Impulse Response (FIR) filters are an important and widely used form of digital filter. FIR filters are used in numerous real time applications including telecommunications, particularly for the generation of constant phase delay characteristics. In addition, signal processing applications requiring interpolation and decimation function incorporate FIR filtration as an integral part of the process.

The output sample of an FIR filter is a convolution summation of input samples and the impulse response of the filter. The output *y(n)* of a causal FIR filter can be written as (equation (1)):

$$y(n) = \sum_{k=0}^{H-1} h(k) * x(n-k)$$

where:

*H* is the total number of filter coefficients, and *n* = 0, 1, 2, 3...; for different values of *n*, the output sample of the filter can be obtained;
*h(k)* is the impulse response of the filter; filter coefficients are determined for various values of *k*; the value of *k* can never be negative for a causal system;
*x(m),* with *m* = *n-k* as shown in equation (1), is the input sample; the value of m can never be negative for a causal system.

As stated by the above equation (1), the filter coefficients are multiplied with the appropriate input samples and summed to obtain the output sample; in other words, for obtaining a particular filter output sample, the filter coefficients are multiplied by the appropriate input samples, and then accumulated.

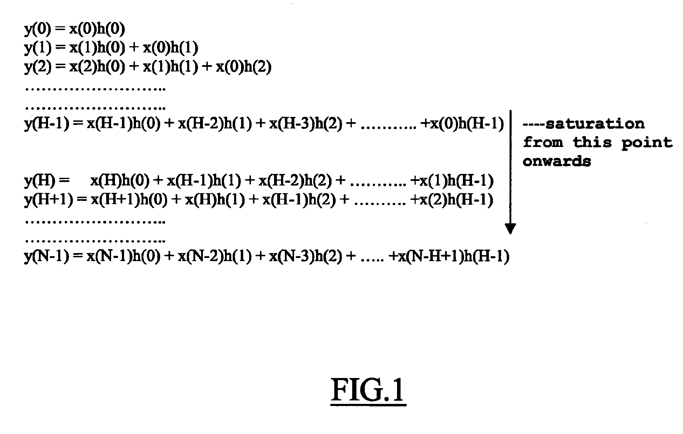

For a number *N* of input samples and a number *H* of coefficients, the required number of multiplications for calculating a given output sample is equal to *H*. The saturation occurs at the *H*th output sample, as shown in **Figure 1.**

The number *H* of multiplications is necessarily required if all the *H* filter coefficients are unique.

Compared to other filters, FIR filters offer several advantages, some of which are discussed in the following.

FIR filters are simple to be designed and implemented. Linear-phase filters that delay the input signal, without causing phase distortion, can be easily realized using FIR filters. FIR filters do not employ any feedback and hence present fewer difficulties in practical implementation. The absence of feedback also simplifies the filter design, by making it possible to use finite precision arithmetic. Multi-rate applications such as "decimation" (reduction in the sampling rate) and "interpolation" (increase in the sampling rate), can be realized best by FIR filters.

FIR filters can be easily implemented using fractional arithmetic, unlike other type of filters in which it is difficult to do so. It is always possible to implement an FIR filter using coefficients with magnitude of less than 1.0, as the overall gain of the FIR filter can be adjusted at the output thereof.

All the above advantages make FIR filters preferable for fixed-point Digital Signal Processors (DSPs).

The conventional approach in FIR filter implementation utilizes a delay line (*m* = *n-k*, as in equation (1)), resulting in increased memory requirements and slower computation.

US patent 5,732,004 describes an algorithm for FIR filtering. That document proposes a method of decimating and/or interpolating a multi-bit input signal in which *n*/2 additions are performed, where *n* is the number of bits in each filter coefficient. Scaling and multiplication of data with coefficients is performed using a standard DSP architecture, using coefficient values and associated scaling factors stored in memory. The coefficients are stored in coded form, and are then decoded prior to multiplication by the data values.

A delay line is essential for the implementation of this method.

US patents 6,260,053 and 5,297,069 describe methods and implementations that utilize delay lines for FIR filter implementation. Moreover, none of these methods provides linear scalability.

In particular, the US patent US 6,260,053 provides a FIR filter that takes advantage of the coefficient symmetry to reduce the number of multiplications typically required in a linear phase FIR filter. More in detail, the number of multiplications is reduced in half by reusing some of the products, thanks to the symmetry in the coefficient sequence that is involved in the filter. Indeed, since same products are needed for different addition operations, there is no need to repeat the same multiplication operations.

In C.H.Dick, "The Scalability of Linear Filter on Hypercube Concurrent Computers", it is reported an implementation of a hypercube arrangement of VLSI DSP processors (TMS320C30) for FIR filtering.

In view of the state of the art outlined in the foregoing, an object of the present invention is to provide an efficient implementation for an FIR filter, particularly for multi-processor architectures.

Another object of the present invention is to provide a linearly scalable FIR filter.

Yet another object of the present invention is to obviate the need of a delay line for implementing an FIR filter, thereby reducing the memory requirement for computation and resulting in a cost effective solution.

It is a further object of the present invention to speed up the computation of FIR filters.

To achieve these and other objects, the present invention provides an improved Finite Impulse Response (FIR) filter as set forth in claim 1.

Furthermore, the present invention also provides a method for implementing an improved Finite Impulse Response (FIR) filter as set forth in claim 2.

The invention will now be described with reference to the accompanying drawings, wherein:

> **Figure 1** shows a generalized set of equations for the outputs of a generic FIR filter with $N$ input/output samples, and H filter coefficients;
> **Figure 2** shows a set of equations for the outputs of an exemplary FIR filter having eleven input/output samples, and six filter coefficients;
> **Figure 3** shows a set of equations for the outputs of an exemplary FIR filter having thirteen input/output samples, and seven filter coefficients;
> **Figure 4** shows a schematic diagram of a Multiprocessor architecture; and
> **Figure 5** shows a schematic diagram of the internal architecture of one processor of a multi-processor architecture.

With reference to the drawings, **Figure 1** shows a generalized set of equations for the outputs of a generic FIR filter with $N$ input/output samples, and $H$ filter coefficients. These equations define the outputs from an FIR filter.

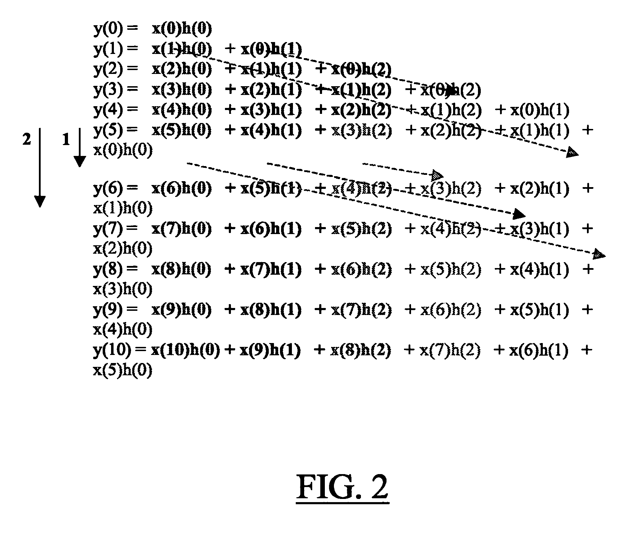

**Figure 2** refers to an example of the output samples of an exemplary symmetric FIR filter having eleven input/output samples, and six filter coefficients. If the total number of coefficients $H$ is an even number, as shown in this example, then it is possible to obtain all the output samples by computing a subset of partial products that involve $H/2$ coefficients. Each of these partial products occurs in two symmetrically spaced samples, and can therefore be computed once and reused thereafter, thereby eliminating the requirement of a delay line and reducing computational time and memory space requirements, as compared to the conventional approach of FIR filter implementation.

In the example of **Figure 2,** output sample $y(5)$ requires the computation of only three partial products, *i.e.* $x(5)h(0)$, $x(4)h(1)$ and $x(3)h(2)$, as the other three partial product terms $x(0)h(0)$, $x(1)h(1)$ and $x(2)h(2)$ have already been computed in previous samples $y(0)$, $y(2)$ and $y(4)$, respectively. Similarly, the partial products $x(5)h(0)$, $x(4)h(1)$ and $x(3)h(2)$ contribute to terms (output samples) $y(10)$, $y(8)$ and $y(6)$, respectively, and so on.

It can be observed from **Figure 2** that a number $P$ of consecutive output calculations can be distributed over $P$ processors simultaneously, provided $P$ consecutive inputs are present. As shown for the case of two processors ($P = 2$), the output samples $y(5)$ and $y(6)$ can be calculated simultaneously.

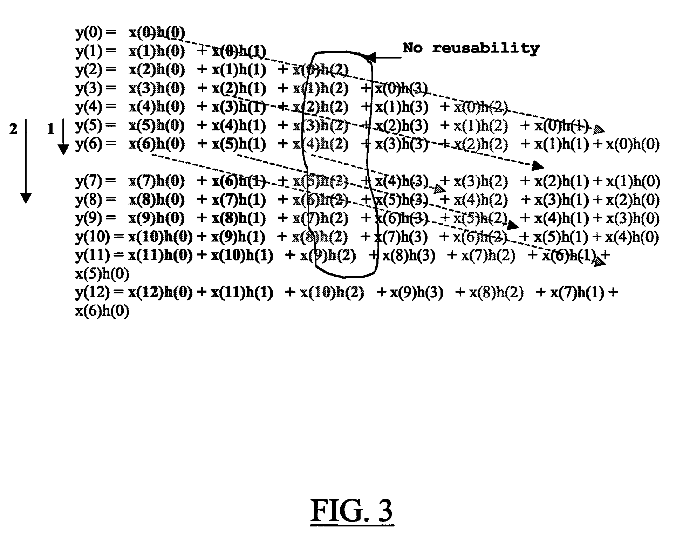

**Figure 3** shows an example of the output samples of another exemplary symmetrical FIR filter having thirteen input/output samples, and seven filter coefficients. If the total number of coefficients $H$ is an odd number, as shown in this example, then it is possible to obtain all the output sample by calculating a maximum number of $((H\text{-}1)/2+1)$ of partial products after the saturation. When the filter coefficient are an odd number, i.e. $H$ is odd, the basic algorithm remains the same as for the case in which the coefficients are an even number, with the exception for the $((H\text{-}1)/2+1)$ th column, around which the **Figure 3** is centre-symmetric. The total number of the multiplications required for each output sample is $((H\text{-}1)/2+1)$ after the saturation. As shown, the product term associated with the coefficient $h(3)$ can not be re-used to calculate the partial summation for any other output sample.

The basic algorithm for symmetric FIR filters computation is as follows:

- initialize loop index by zero;
- load input sample and coefficients;
- multiply input sample and coefficient;
- update current output;
- update partial output, if required (see *Note* below);
- increment loop index by number of processors;
- if loop termination is a condition satisfied, then stop, else go to second step.

*Note:* for the centro-symmetric case, one product term is never re-used.

For the exemplary case of a two parallel-processors architecture, the basic algorithm is modified as follows:

- initialize loop-index by zero;
- load input sample for processor #1;
- load coefficient for processor #1;
- multiply input sample and coefficient in processor #1;
- update current output in processor #1;
- update partial output, if required, in processor #1;
- load input sample for processor #2;
- load coefficient for processor #2;
- multiply input sample and coefficient in processor #2;
- update current output in processor #2;
- update partial output, if required, in processor #2;
- increment loop-index by 2;
- if loop-index equal to *(N\*H)* then stop, else go to second step.

The algorithm can be generalized for any number of processors in parallel.

Furthermore, the algorithm is also applicable for the asymmetric FIR Filters, according to the following steps:

- initialize loop index by zero;
- load input sample and coefficients;
- multiply input sample and coefficient;

- update current output;
- increment loop index by number of processors;
- if loop termination is a condition satisfied, then stop, else go to second step.

Each processor in the parallel processing architecture is provided with an independent ALU (Arithmetic and Logic Unit), multiplier unit, data cache, and load/store unit. All the processors share a common instruction cache (hereinafter, I-cache), and multi-port memory. This architecture is typical of VLIW (Very Long Instruction Word) processors.

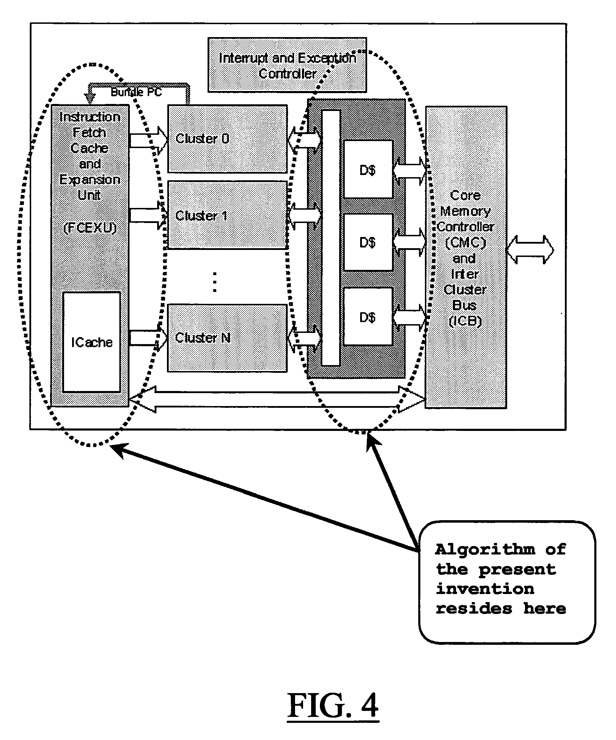

**Figure 4** shows the typical architecture of a Very Long Instruction Word (VLIW) processor core. It is a multi-processor architecture in which each processor is composed of a mix of register banks, constant generators (immediate operands) and functional units. Different processors may have different unit/register mixes, but a single program counter and a unified I-cache control them all, so that all processors run in lockstep (as expected in a VLIW). Similarly, the execution pipeline drives all processors. Inter-processor communication, achieved by explicit register-to-register move, is compiler-controlled and invisible to the programmer. At the multi-processor level, the typical architecture specification for such a device is as follows:

- an instruction delivery mechanism is provided to get instructions from the cache to the processors' datapath;
- an inter-processor communication mechanism is provided to transfer data among processors;
- the data-cache is organized to establish a guarantee of main memory coherency in the presence of multiple memory accesses.

The algorithm to compute output samples resides in the instruction fetch cache and expansion unit.

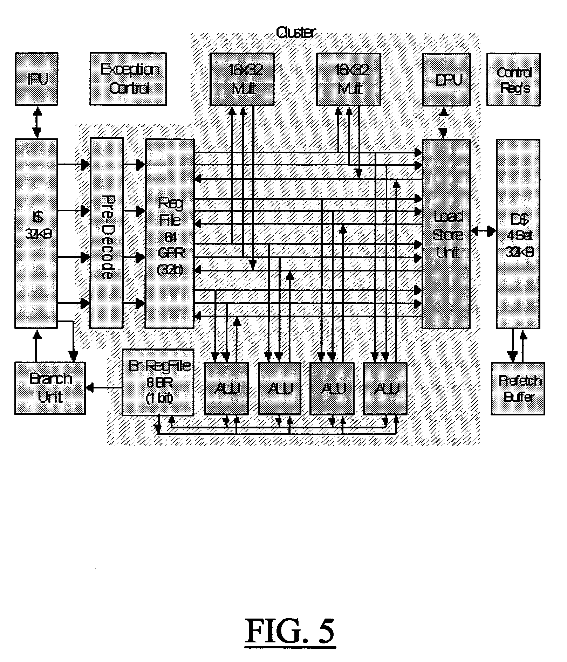

**Figure 5** shows the schematic diagram of the internal architecture of a generic one of the processors. Generally speaking, a processor is a four-issue (a maximum of four instructions can be issued simultaneously) VLIW core comprising the following elements:

- four thirty-two-bit integer ALUs, two 16x32 multipliers, one load/store unit and one branch unit;
- sixty-four thirty-two-bit general-purpose registers, and eight one-bit branch registers (used to store branch condition, predicates and carries);instructions allow two long immediate data operands per cycle.

The instruction set architecture is a very simple integer RISC instruction set with minimal "predication" support through select instructions.

The memory-addressing repertoire includes base plus offset addressing, allows speculative execution (dismissible loads, handled by the protection unit) and software pre-fetching.

The instant invention utilizes this architecture to provide faster computation, as it is evident from the fact that, if any FIR filter takes $T$ units of time to compute $N$ outputs in one processor, then, for the increased number of processors (say $P$), the time required to compute $N$ outputs will be $T/P$ units of time, which provides 'linear scalability'. Furthermore, since all the processors load input samples and coefficients from the shared memory where both the data are available, there is no requirement for any delay line.

The instant invention is not limited in scope to non-unique filter coefficients, since both the non-utilization of delay line and the linear scalability can be realized as well for all unique coefficients.

**Claims**

1. An improved symmetric Finite Impulse Response filter implemented without delay lines, comprising:

   - a multiprocessor architecture including a plurality of processing units, each one including a respective Arithmetic and Logic Unit, a multiplier unit, a data cache, and a load/store unit, the plurality of processing units sharing a common instruction cache and a multi-port memory for storing input samples and coefficients, and
   - an assigning means for assigning to each available processing unit the computation of corresponding partial product terms starting from a corresponding input sample and a corresponding coefficient,

   wherein the partial product terms are accumulated to compute a corresponding output sample value, each partial product term that contributes to two output samples being computed once for one of the two output samples and reused thereafter for the other of the two output samples,
   said multiprocessor architecture providing linear scalability so that a time required to calculate a certain number of outputs performed by the filter is scaled down by the number of processing units of the plurality.

2. A method for implementing a symmetric Finite Impulse Response filter implemented without delay lines, the filter comprising a multiprocessor architecture including a plurality of processing units, each one including a respective Arithmetic and Logic Unit, a multiplier unit, a data cache, and a load/store unit, the plurality of processing units sharing a common instruction cache and a multi-port memory for storing input samples and coefficients, the method comprising the steps of :

- assigning to each available processing unit the computation of corresponding partial product terms starting from a corresponding input sample and a corresponding coefficient, and
- accumulating the partial product terms to compute a corresponding output sample value, each partial product term that contributes to two output samples being computed once for one of the two output samples and reused thereafter for the other of the two output samples, wherein:

- said multiprocessor architecture provides linear scalability so that a time required to calculate a certain number of outputs performed by the filter is scaled down by the number of processing units of the plurality.

**Patentansprüche**

1.  Verbessertes symmetrisches, ohne Verzögerungsleitungen implementiertes Filter mit endlicher Impulsantwort, aufweisend:

    - eine Multiprozessor-Architektur mit einer Mehrzahl von Verarbeitungseinheiten, von denen jede ein entsprechendes Rechenwerk, eine Multipliziereinheit, einen Daten-Cache sowie eine Lade-/Speichereinheit umfaßt, wobei die Mehrzahl von Verarbeitungseinheiten einen gemeinsamen Instruktions-Cache sowie einen Multiport-Speicher zum Speichern von Eingabeabtastwerten und Koeffizienten gemeinsam nutzt, und
    - eine Zuordnungseinrichtung zum Zuordnen der Berechnung entsprechender partialer Produktterme zu jeder verfügbaren Verarbeitungseinheit, ausgehend von einem entsprechenden Eingabeabtastwert sowie einem entsprechenden Koeffizienten, wobei die partialen Produktterme aufsummiert werden, um einen entsprechenden Ausgabe-Abtastwert zu berechnen, wobei jeder partiale Produktterm, der zu zwei Ausgabeabtastwerten beiträgt, ledglich für einen der beiden Ausgabewerte berechnet und anschließend für den anderen der beiden Ausgabeabtastwerte wiederverwendet wird, wobei die Multiprozessor-Architektur eine lineare Skalierbarkeit vorsieht, so dass eine zum Berechnen einer bestimmten Anzahl von Ausgabewerten, welches durch das Filter durchgeführt wird, benötigte Zeit durch die Anzahl der Verarbeitungseinheiten aus der Mehrzahl der Verarbeitungseinheiten vermindert wird.

2.  Verfahren zum Implementieren eines symmetrischen Filters mit endlicher Impulsantwort, welches ohne Verzögerungsleitungen implementiert ist, wobei das Filter eine Multiprozessor-Architektur mit einer Mehrzahl von Verarbeitungseinheiten umfasst, von denen jede ein entsprechendes Rechenwerk, eine Multipliziereinheit, einen Daten-Cache sowie eine Lade-/Speichereinheit umfasst, wobei die Mehrzahl von Verarbeitungseinheiten einen gemeinsamen Instruktions-Cache sowie einen Multiport-Speicher zum Speichern von Eingabeabtastwerten und Koeffizienten gemeinsam nutzt, wobei das Verfahren folgende Schritte umfaßt:

- Zuordnen der Berechnung entsprechender partialer Produktterme zu jeder verfügbaren Verarbeitungseinheit, ausgehend von einem entsprechenden Eingabeabtastwert und einem entsprechenden Koeffizienten, und
- Aufsummieren der partialen Produktterme zum Berechnen eines entsprechenden Ausgabe-Abtastwertes, wobei jeder partiale Produktterm, der zu zwei Ausgabeabtastwerten beiträgt, nur einmal für einen von den beiden Ausgabe-Abtastwerten berechnet und danach für den anderen der beiden Ausgabeabtastwerte wiederverwendet wird, wobei:

- die Multiprozessorarchitektur eine lineare Skalierbarkeit vorsieht, so dass eine zum Berechnen einer bestimmten Anzahl von Ausgabewerten, welches durch das Filter durchgeführt wird, benötigte Zeit durch die Anzahl der Verarbeitungseinheiten aus der Mehrzahl der Verarbeitungseinheiten vermindert wird.

**Revendications**

1.  Filtre à Réponse Impulsionnelle Finie symétrique et amélioré, mis en oeuvre sans lignes de retard, comprenant :

    une architecture multiprocesseur comprenant une pluralité d'unités de traitement, chacune d'elles comprenant une Unité Arithmétique et Logique respective, une unité de multiplication, un cache de données, et une unité de chargement/mémorisation, la pluralité d'unités de traitement partageant un cache d'instructions commun et une mémoire à ports d'accès multiples pour mémoriser des échantillons d'entrée et des coefficients, et
    des moyens d'affectation pour affecter à chaque unité de traitement disponible le calcul de termes de produits partiels correspondants en commençant à partir d'un échantillon d'entrée correspondant et d'un coefficient correspondant,

dans lequel les termes de produits partiels sont accumulés pour calculer une valeur d'échantillon de sortie correspondante, chaque terme de produit partiel qui contribue à deux échantillons de sortie étant calculé une fois pour l'un des deux échantillons de sortie et réutilisé ensuite pour l'autre des deux échantillons de sortie,

l'architecture multiprocesseur assurant une extensibilité linéaire de sorte que le temps nécessaire pour calculer un certain nombre de sorties produites par le filtre est réduit par le nombre d'unités de traitement de la pluralité.

2.　Procédé pour mettre en oeuvre un filtre à Réponse Impulsionnelle Finie symétrique, mis en oeuvre sans lignes de retard, le filtre comprenant une architecture multiprocesseur comprenant une pluralité d'unités de traitement, chacune d'elles comprenant une Unité Arithmétique et Logique respective, une unité de multiplication, un cache de données, et une unité de chargement/mémorisation, la pluralité d'unités de traitement partageant un cache d'instructions commun et une mémoire à ports d'accès multiples pour mémoriser des échantillons d'entrée et des coefficients, le procédé comprenant les étapes suivantes :

affecter à chaque unité de traitement disponible le calcul de termes de produits partiels correspondants en commençant à partir d'un échantillon d'entrée correspondant et d'un coefficient correspondant, et

accumuler les termes de produits partiels pour calculer une valeur d'échantillon de sortie correspondante, chaque terme de produit partiel qui contribue à deux échantillons de sortie étant calculé une fois pour l'un des deux échantillons de sortie et réutilisé ensuite pour l'autre des deux échantillons de sortie, dans lequel :

l'architecture multiprocesseur assure une extensibilité linéaire de sorte que le temps nécessaire pour calculer un certain nombre de sorties produites par le filtre est réduit par le nombre d'unités de traitement de la pluralité.

$y(0) = x(0)h(0)$
$y(1) = x(1)h(0) + x(0)h(1)$
$y(2) = x(2)h(0) + x(1)h(1) + x(0)h(2)$
...........................
...........................
$y(H-1) = x(H-1)h(0) + x(H-2)h(1) + x(H-3)h(2) + ............ +x(0)h(H-1)$     ----saturation from this point onwards

$y(H) = \quad x(H)h(0) + x(H-1)h(1) + x(H-2)h(2) + ............ +x(1)h(H-1)$
$y(H+1) = x(H+1)h(0) + x(H)h(1) + x(H-1)h(2) + ........... +x(2)h(H-1)$
...........................
...........................
$y(N-1) = x(N-1)h(0) + x(N-2)h(1) + x(N-3)h(2) + ...... +x(N-H+1)h(H-1)$

# FIG.1

y(0) = x(0)h(0)
y(1) = x(1)h(0) + x(0)h(1)
y(2) = x(2)h(0) + x(1)h(1) + x(0)h(2)
y(3) = x(3)h(0) + x(2)h(1) + x(1)h(2) + x(0)h(2)
y(4) = x(4)h(0) + x(3)h(1) + x(2)h(2) + x(1)h(2) + x(0)h(1)
y(5) = x(5)h(0) + x(4)h(1) + x(3)h(2) + x(2)h(2) + x(1)h(1) + x(0)h(0)

y(6) = x(6)h(0) + x(5)h(1) + x(4)h(2) + x(3)h(2) + x(2)h(1) + x(1)h(0)

y(7) = x(7)h(0) + x(6)h(1) + x(5)h(2) + x(4)h(2) + x(3)h(1) + x(2)h(0)

y(8) = x(8)h(0) + x(7)h(1) + x(6)h(2) + x(5)h(2) + x(4)h(1) + x(3)h(0)

y(9) = x(9)h(0) + x(8)h(1) + x(7)h(2) + x(6)h(2) + x(5)h(1) + x(4)h(0)

y(10) = x(10)h(0) + x(9)h(1) + x(8)h(2) + x(7)h(2) + x(6)h(1) + x(5)h(0)

# FIG. 2

y(0) = x(0)h(0)

y(1) = x(1)h(0) + x(0)h(1)

y(2) = x(2)h(0) + x(1)h(1) + x(0)h(2)

y(3) = x(3)h(0) + x(2)h(1) + x(1)h(2) + x(0)h(3)

y(4) = x(4)h(0) + x(3)h(1) + x(2)h(2) + x(1)h(3) + x(0)h(2)

y(5) = x(5)h(0) + x(4)h(1) + x(3)h(2) + x(2)h(3) + x(1)h(2) + x(0)h(1)

y(6) = x(6)h(0) + x(5)h(1) + x(4)h(2) + x(3)h(3) + x(2)h(2) + x(1)h(1) + x(0)h(0)

**No reusability**

y(7) = x(7)h(0) + x(6)h(1) + x(5)h(2) + x(4)h(3) + x(3)h(2) + x(2)h(1) + x(1)h(0)

y(8) = x(8)h(0) + x(7)h(1) + x(6)h(2) + x(5)h(3) + x(4)h(2) + x(3)h(1) + x(2)h(0)

y(9) = x(9)h(0) + x(8)h(1) + x(7)h(2) + x(6)h(3) + x(5)h(2) + x(4)h(1) + x(3)h(0)

y(10) = x(10)h(0) + x(9)h(1) + x(8)h(2) + x(7)h(3) + x(6)h(2) + x(5)h(1) + x(4)h(0)

y(11) = x(11)h(0) + x(10)h(1) + x(9)h(2) + x(8)h(3) + x(7)h(2) + x(6)h(1) + x(5)h(0)

y(12) = x(12)h(0) + x(11)h(1) + x(10)h(2) + x(9)h(3) + x(8)h(2) + x(7)h(1) + x(6)h(0)

# FIG. 3

Algorithm of the present invention resides here

FIG. 4

## FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5732004 A
- US 6260053 B

- US 5297069 A